# EUROPEAN PATENT APPLICATION

(11) **EP 3 364 579 A1**
(43) Date of publication of application: **22.08.2018**
(21) Application number: 17157201.9
(22) Date of filing: 21.02.2017
(51) Int. Cl.: H04L 1/00, H04L 1/08, H03M 13/37

(54) **RECEIVER, TRANSMITTER, TRANSMISSION SYSTEM AND METHODS FOR RECEIVING AND TRANSMITTING MESSAGES**

(71) Applicant: Fraunhofer-Gesellschaft zur Förderung der angewandten Forschung e.V., 80686 München (DE)
(72) Inventor: KILIAN, Gerd, 91056 Erlangen (DE); BREILING, Marco, 91052 Erlangen (DE); KURRAS, Martin, 13357 Berlin (DE); KRISHNAMOORTHY, Aravindh, 90425 Nürnberg (DE); MORGADE PRIETO, Javier, 90762 Fürth (DE); NIEMANN, Bernhard, 91056 Erlangen (DE); BERNHARD, Josef, 92507 Nabburg (DE); KASPARICK, Martin, 12435 Berlin (DE); KEUSGEN, Wilhelm, 14089 Berlin (DE); GÜL, Serhan, 13357 Berlin (DE); HEUBERGER, Albert, 91056 Erlangen (DE)
(74) Representative: Stöckeler, Ferdinand

(57) **Abstract**

A receiver comprising a receive unit, wherein the receiver is configured to receive a signal. The signal comprises a coded message representing a message, commonly coded using an FEC code with such a correlated decoded message is decodable upon receipt of a subportion in time of the coded message or upon receipt of the subportions of different transmissions of the coded message. If there is a sequence of different transmissions associated with a message, a counter indicating the position of the respective transmission of sequences not commonly coded where the message is associated with the respective transmission. Moreover, the receiver is configured to switch on the receive unit for a time period long enough to obtain the subportion or subportions of the coded message and to decode the coded message.

## Description

### Technical Field

Embodiments of the present invention relate to receivers, a transmitter, a transmission system and methods for receiving and transmitting messages.

### Background of the Invention

It has been found that loT (Internet of Things) devices shall consume very little power, whenever they are not actively transmitting. This may be realized by a kind of low power mode, where only a very small subset of the device functionality is active while other parts, especially the receiver and transmitter branches are powered down (inactive).

However, it has been found that there are two requirements that are incompatible with such a low power mode.

Firstly, a core network and a base station might want to initiate an action of the loT device(s) (either of an individual device, or a group, or all devices). For instance, this could be the measurement of some sensor data by the device(s) and its transmission to the base station. However, when the receiver branch is inactive, the loT device cannot receive such requests and react.

Secondly, it might be preferable that the transmission from an ensemble of loT devices to the base station is using a slotted structure of the time and frequency resources. This means that the time is partitioned into time slots and the frequency is partitioned into frequency slots/channels, and that an loT device must start and terminate its transmissions at the boundaries of these time slots and remain within the boundaries of the frequency slots/channels. Such a slotted structure reduces the probability that a transmitted burst is partly overlapped and thus interfered by the transmission of another loT device. Such a time/frequency slotted transmission requires, however, a sufficiently accurate time and frequency synchronization among all loT devices and/or among the loT devices and the base stations. However, when the receiver branch is inactive, such a synchronization is not possible.

In conventional approaches, the loT devices switch on the receive branches (receive units) at regular intervals in order to receive a signal from a base station. The signal may comprise a synchronization signal, a control signal, or a combination, i.e. a synchronization-plus-control signal. The synchronization signal may be used to synchronize a clock of a receiver to a clock of a transmitter and the control signal (i.e. the message) may be used for conveying commands to a receiver, which may be used to operate the receiver or to operate a device which incorporates the receiver. Furthermore, the base station transmits the signal all the time or only at regular intervals.

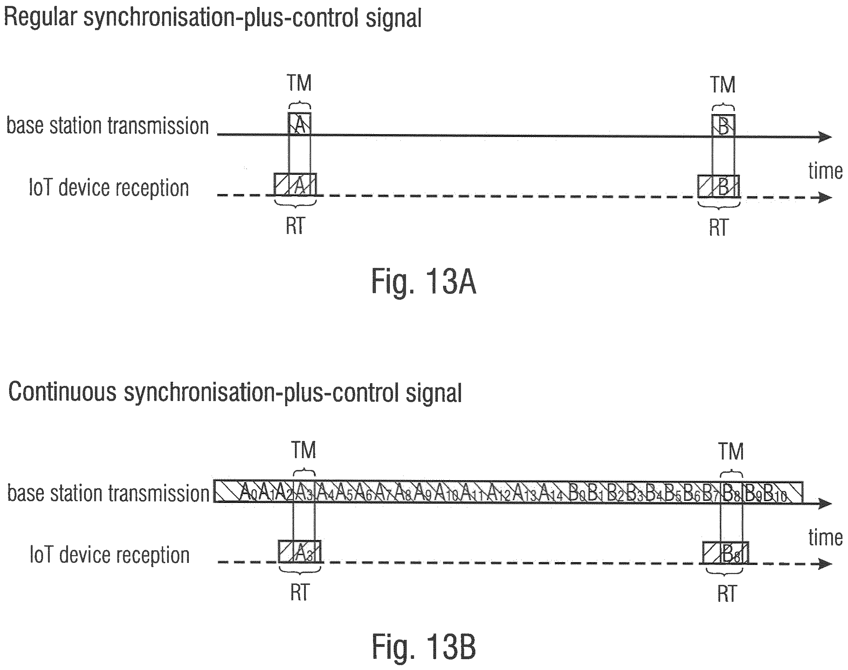

Fig. 13A shows a conventional scenario in which messages 'A' and 'B', which represent synchronization-plus-control signal bursts having a burst length TM, are transmit periodically, i.e. at regular intervals. Because of the timing offsets of the loT device's internal clock, in such conventional approaches, the loT device has to pull up its receive branch, i.e. switch on its receive unit, in advance with respect to the start of the synchronization-plus-control signal burst, such that it receives the complete burst even in the presence of a synchronization offset (i.e. when a time reference of the loT device is ahead or behind a time reference of the base station). Similarly, it has been found that the receive unit of the loT device has to be switched on for a time longer than the actual burst length TM, such that the full burst may be received even in case of a synchronization offset (e.g. if the reception starts significantly earlier than the burst), because processing requires some time before the loT device can decide that the full burst has actually been captured. This situation is illustrated in Fig. 13A, wherein the receive unit of the loT device is switched on for a time period RT.

Fig. 13B shows a conventional scenario in which the synchronization-plus-control signal is sent continuously. In case of a continuous signal, the base station occupies the synchronization-plus-control channel 100% of the time, even though the actual message ('A' or 'B' in the figures) is conveyed in a relatively short section of duration TM, which however is repeated many times. In conventional approaches, each repetition comprises a counter that is incremented each time the message is sent, in order to give the loT device an indication of where this message is located in time, e.g. within the frame transmitting the message A and before the start of the frame transmitting the message B. The counter is indicated in Fig. 13B by a respective subscript index. The counter is appended to the message payload prior to Forward Error Correction (FEC) encoding and modulating a signal comprising the message and the counter. Due to the joint encoding of repeated message payloads ('A', which does not change over the repetitions until a new message payload B is transmitted) and counter values, the transmitted (coded) messages A₀, A₁, A₂,... differ from each other (i.e. each of these messages has an individual content, which is indicated by the subscript index). Since the loT device may and will not be perfectly aligned to the pattern of repeated messages, it has to switch on the receive unit thereof sufficiently in advance before the expected start of a message, such that it does not miss the (start of the) message even in case of a synchronization offset. Likewise, the loT device has to switch off the receive unit sufficiently after the expected end of the message. This is shown by respective switch on times RT in Fig. 13B. Accordingly, also in this case the loT device has to switch on the receive unit thereof for a time period RT longer than the actual message length TM.

Alternative conventional approaches use a wakeup receiver (cf. H. Milosiu and F. Oehler, "Sub-10 µW CMOS wake-up receiver IP for green SoC designs," SOC Conference (SOCC), 2013 IEEE 26th International, Erlangen, 2013), which has an ultra-low power receiver circuit running all the time and listening to a control (potentially plus synchronization) signal from the base station. In this alternative, the base station can transmit a wakeup burst at an arbitrary time and is not confined to either transmitting continuously or at regular intervals. Once the wakeup signal is received, a controller connected to the wakeup receiver can power up further circuits within the loT device and carry out the requested action. The drawback of this solution is its bad reception sensitivity (the received wakeup signal has to be relatively strong in order to trigger the wakeup device) and its bandwidth inefficiency (the wakeup burst has to be relatively long in time while it conveys only a short message).

Therefore, a desire exists for an improved concept for receiving and transmitting messages, in particular in the context of loT devices.

### Summary of the Invention

The invention provides a receiver according to claim 1, a transmitter according to claim 12, a transmission system according to claim 20, a receiver according to claim 23 and methods for receiving and transmitting messages according to claims 28 to 31. Embodiments provide a receiver comprising a receive unit, wherein the receiver is configured to receive a signal. The signal comprises a coded message representing a message, commonly coded using an FEC code, with such a code rate that a coded message is decodable upon receipt of the subportion in time of the coded message or upon reception of subportions of different transmissions of the coded message. Furthermore, if there is a sequence of different transmissions associated with the message, a counter indicating the position of the respective transmission in a sequence and not commonly coded with the message is associated with a respective transmission. Moreover, the receiver is configured to switch on the receive unit for a time period long enough to obtain the subportion or subportions of the coded message and to decode the coded message.

Such a receiver may be particularly suited for applications in which power consumption is a concern. Since the receiver may successfully decode the coded message although only a part/subportion or subportions of different transmissions associated with the message are received, the switch on time of the receive unit of the receiver may be reduced when compared to conventional approaches. Since the receiver may not be required to receive the entire coded message to decode the coded message and to obtain the message therefrom, the receiver may switch off its receive unit after acquiring the subportion or subportions. Furthermore, switching off the receive unit may be particularly beneficial with respect to power saving as the receive unit may have an analog circuit architecture. Generally, analog circuitry may be more power consuming than digital circuitry which may form portions of the remaining receiver circuitry. Thus, the longer the receive unit may be switched off the larger the power saving may be. Moreover, as the receiver may be able to decode the message based on a subportion or subportions of the coded message, the entire received signal may be useful for obtaining the message. This is in contrast to conventional concepts which usually require to switch on a receive unit for a longer time period such that a signal is received which may contain periods without any signal present or which include a signal not associated with the message. The receiver may further be able to decode the message based on subportions obtained from different transmissions associated with a message, wherein a counter indicating the position of the respective transmission may be arranged between the different transmissions and therefore may be part of the received signal. As the counter is not commonly coded with the message the receiver may still be able to decode the message based on the subportions since the counters separating the subportions are not jointly FEC coded with the message. This is different from conventional concepts, wherein each transmission is separately coded with the respective counter, such that decoding of the message based on subportions of different transmissions of the message is hampered. Thus, the receiver can flexibly decode the message based on either a subportion or subportions of different transmissions without an overhead incurred for ensuring the reception of a complete transmission associated with the message.

In embodiments the receiver is configured to switch on its receive unit for a time period not longer than the length of the coded message. Using the described receiver enables reception of subportions which are based on particularly short switch on times of the receive unit. Reducing the length of the switch on times of the receive unit is beneficial, as a receive unit may consume considerably more power than other components of the receiver.

In embodiments the receiver is configured to obtain a control information from the received signal, wherein the receiver may be configured to adjust a characteristic of the time period based on the control information obtained from the received signal. Thus, the length of the time period may be adjusted such that a sufficiently sized subportion of the coded message is obtained to enable decoding of the coded message. Thereby, the time period can be shortened such that a maximum energy saving may be obtained by reducing the switch on times of the receive unit to a minimum time.

In embodiments the receiver is configured to adjust a periodicity of the time period based on the control information obtained from the received signal in order to synchronize switch-on times of the receive unit to transmission times of the message. For example, if the message is only available at certain intervals in time the receiver can be configured to switch on its receive unit such that the switch-on times of the receive unit overlap with the transmission times of the message such that it obtains a subportion of the coded message to be able to decode the message and, moreover, does not waste switch-on times for time intervals where no signal may be present and therefore receivable.

In embodiments the receiver is configured to obtain a synchronization information from the receive signal, wherein the receiver is configured to adjust a clock of the receiver, used for sampling of the received signal, based on the synchronization information. Thus, the receiver can decode the message with low computational complexity, as coherent demodulation enables concepts for simple receiver structures with low computational power and, therefore, low energy consumption.

In embodiments the receiver is configured to adjust the length of the received signal such that the synchronization information is obtained from the received signal. The length of the received signal can be adjusted, for example, by increasing the length of the time period during which the signal is received, thereby ensuring reception of at least one synchronization information portion in the received signal. The synchronization information may be located dispersed in the received signal or as a continuous large block inside the received signal and, therefore, the receive unit may be flexibly configured to switch on its receive unit for a sufficient time to obtain the synchronization information.

In embodiments the receiver is configured to obtain a synchronization information on the basis of a cross-correlation performed on the received signal. Thus, the synchronization may be achieved in a simple manner by cross-correlating the received signal with a reference signal. This may reduce the complexity of the receiver and, therefore, may reduce power consumption. Furthermore, the cross correlation may be performed using sequences with advantageous correlation properties. For example, such sequences may be maximum length codes or gold codes.

In embodiments the receiver is configured to adjust a length of the time period for which the receive unit is switched on to be dependent on a signal-to-noise ratio. This enables a flexible tradeoff between ensuring reception quality and power consumption of the receiver. Coding a message using a coding algorithm that allows the message to be decoded upon receipt of a subportion or subportions of different transmissions may allow a short reception time period on the one hand, but may evoke a decoder with a high complexity on the other hand. Generally, such a decoder may be based on digital circuitry so that there will still be an overall power saving due to the reduced time the receive unit (which may generally include analog circuitry) is switched on.

Embodiments of the invention, such as the receivers and methods for receiving messages described herein, are implemented in portable devices, such as loT devices, since power consumption may be an important factor for such devices which are commonly powered by batteries.

In embodiments the receiver is configured to increase the length of a time period for which the receive unit is switched on if a current signal-to-noise ratio is lower than a previously observed signal-to-noise ratio. Using knowledge of a previously observed signal-to-noise ratio to increase the length of a time period for a currently received signal may enable reception quality improvement for the currently received signal. Moreover, using a previously determined signal-to-noise ratio may save the complexity and time for determining the current signal-to-noise ratio prior to receiving the signal. Moreover, signal-to-noise ratios may be determined on a regular basis, wherein the actual signal-to-noise ratio may be used up to the next determination. An evolution of previously determined signal-to-noise ratios may be used to predict a current signal to noise ratio.

In embodiments the receiver is configured to switch on the receive unit and to switch off the receive unit in response to not observing a receive signal. In other words, the receiver may be configured to immediately switch off the receive unit if a receive signal is not observed upon switching on the receive unit. Thus, additional power may be saved in cases in which there is not any signal that allows a message to be decoded.

In embodiments the coded message may be coded with an erasure code, wherein the receiver may be configured to decode the message based on the subportion of the coded message. Using an erasure code enables decoding of a message based on a subportion of the decoded message without the need to receive the entire coded message. Moreover, the receiver may use a subportion of the coded message, which is proportional in length (e.g. substantially equal in length) to the message, to decode the message. Erasure codes used may for example be fountain codes (e.g. raptor codes, online codes or LT Codes) or Reed-Solomon codes.

In embodiments the coded message may be coded by repeating the message and the receiver is configured to decode the message upon reception of one repetition of the message or upon reception of subportions of at least two repetitions of the message. Coding a message with a repetition code is a simple way of adding redundancy to a coded message and may enable a simple decoding procedure.

Embodiments provide a transmitter configured to commonly encode a message into a coded message using an FEC code with such a code rate that the coded message is decodable upon receipt of a subportion in time of the coded message or upon receipt of subportions of different transmissions of the coded message. Moreover, the transmitter is configured to generate a sequence of different transmissions associated with a message, in which a counter indicating the position of the respective transmission in the sequence and not commonly coded with the message is associated with a respective transmission.

Furthermore, the transmitter is configured to transmit the sequence of different transmissions.

Such a transmitter may increase the reliability that the message is decoded correctly at the receiver's end, as it enables a flexible decoding of the message based on a subportion or subportions of different transmissions of the coded message. Moreover, as the counter is not commonly coded with a message it may be ignored when decoding the coded message. Furthermore, the transmitter may enable a flexible decoding of the coded message by a receiver, which may be a portable or battery powered device and therefore benefits from flexibility in terms of switch on times of its receive unit to save energy.

In embodiments the transmitter is configured to include a control information to the transmitted sequence of different transmissions, wherein the control information may be configured to adjust a time period used for reception of the transmitted signal of a receiver. Transmitting control information enables a receiver to switch on its receive units only when, for example, a new message is transmitted by the transmitter. Therefore, additional power saving may be achieved at the receiver's end.

In embodiments the control information is configured to synchronize switch-on times of a receiver with transmission times of the message. This enables the receiver to switch on its receive unit only when it is appropriate for receiving the coded message (e.g. when a signal is available associated with a not yet received message).

In embodiments the transmitter is configured to include a synchronization information into the transmitted sequence of different transmissions, wherein the synchronization information is configured to adjust to a clock of a receiver used for sampling the transmitted signal upon reception by the receiver. The synchronization information may be a clock correction information such that a coherent demodulation of the received signal may be achieved in an easy manner, reducing computational complexity requirements for the receiver.

In embodiments the transmitter is configured to periodically include synchronization information into the transmitted sequence such that the receiver is able to obtain a synchronization information upon reception of a subportion of the transmitted sequence. A subportion may have a minimum length corresponding to a length of the message enabling decoding of the message based on the subportion. Therefore, the transmitted sequence may be interspersed with synchronization information having a minimum distance corresponding to the length of the message or two times the length of the message.

In embodiments the synchronization information is included in the transmitted signal such that it enables a cross-correlation based retrieval of the synchronization information by the receiver. For example including maximum length codes or gold codes into the transmitted signal enables a receiver to obtain the synchronization information by a simple cross-correlation with a predefined sequence included by the transmitter into the transmission.

In embodiments the transmitter is configured to obtain the coded message by coding the message with an erase code, such that a receiver is able to decode the message upon reception of a subportion of the coded message. Using an erasure code enables the receiver to flexibly decode the message upon reception of a subportion of the coded message. Therefore, the receiver may not be required to receive a signal corresponding in length to the coded message, but only a signal corresponding in length to a subportion of the coded message. Thereby, the transmitter enables the receiver to reduce its switch-on times.

In embodiments the transmitter is configured to obtain the coded message by coding the message by repeating the message such that a receiver is able to decode the message upon reception of one repetition of the message or upon reception of subportions of at least two repetitions of the message. Using a repetition code enables a simple encoding procedure and therefore a simple transmitter as a small computational complexity is incurred by using a repetition code. Moreover, repetition codes enable a simple decoder structure in the receiver.

Embodiments provide a transmission system comprising a receiver as described herein and a transmitter. The receiver is configured to receive a signal comprising a coded message representing a message, commonly coded using an FEC code with such a code rate that a coded message is decoded upon receipt of a subportion in time of the coded message or upon receipt of subportions of different transmissions of the coded message. If there is a sequence of different transmissions associated with the message, a counter indicating the position of the respective transmission in a sequence and not commonly coded with the message that is associated with a respective transmission. The transmitter is configured to transmit said signal and the receiver is configured to switch on the receive unit for a time period long enough to obtain a subportion of the coded message and to decode the coded message.

The described transmission system enables a power-saving communication between the receiver and the transmitter for the reasons set forth above.

In embodiments the transmitter is configured to transmit the sequence of different transmissions associated with the message. Having a transmitter transmitting a sequence, in contrast to transmitting a single burst, enables a receiver to more flexibly switch on its receive unit. The flexibility is provided by the fact that a sequence is available longer in time compared to a burst transmission and therefore a power saving adjustment of switch-on times of the receive unit of the receiver may be achieved.

In embodiments the transmitter is configured to periodically transmit coded messages, with such a code rate that the coded messages are decodable upon reception of subportions of the coded messages. The described transmitter is beneficial, as it may, for example, transmit each coded message in a single burst. A single burst can be beneficial, as it occupies less time and therefore increases time bandwidth and efficiency. In other words, a channel may only be occupied during times of transmission of the burst.

In embodiments the transmitter is configured to advance the transmission of a message according to the known, assumed or measured frequency stability of the receiver's local oscillator, or the receiver is configured to delay the switch-on time of its receive unit according to the known, assumed or measured frequency stability of the receiver's local oscillator. For instance, if the probability is less than a given percentage y % that the receiver's internal time deviates more than x ms from the nominal switch-on time, then the aforementioned time advance or delay, respectively, could be x ms. This shifting of the transmit or the receive start time ensures that the transmit message is already present on-the-air when the receiver starts its receive unit and hence enables minimum switch-on duration of the receive unit.

Embodiments provide a receiver comprising a receive unit wherein the receiver is configured to switch on the receive unit for a time period in order to receive a signal comprising a message. Moreover, the receiver is configured to adjust the length of the time period for which the receive unit is switched on for receiving a signal, based on a signal-to-noise ratio. Such a receiver may adjust the time necessary to ensure a proper reception of a message based on a signal to noise ratio. For example, the receiver may switch on its receive unit for a long time period if a signal-to-noise ratio is small and for a short time period if the signal-to-noise ratio is high. Thus, the time period during which the receive unit is switched on may be reduced dependent on the signal to noise ratio. As explained above, on the one hand, reducing the time period during which the receive unit (generally including analog circuitry) is switched on may more than compensate the additional power consumption due to the additional computing effort in the digital circuitry of the receiver. On the other hand, having the flexibility to vary (increase if necessary) the switch on times of the receive unit for reception of the message may ensure safe reception of the message. In embodiments the received signal comprises a subportion in time of a message, wherein the message is coded with such a code rate that it is decodable based on the received subportion and the receiver is configured to decode the message. The described embodiment is advantageous as it, for example, allows decoding of a message when the received signal is strongly distorted by noise. Sophisticated codes, for example rateless/fountain codes, may be used for coding the message and therefore a short and noisy (i.e. low signal-to-noise ratio) reception may be compensated by computational effort used for decoding the coded message.

In embodiments such a receiver is configured to receive a pilot signal including a currently received signal portion and to determine a signal-to-noise ratio based on the received pilot signal. Determination of the signal-to-noise ratio based on a pilot signal enables determining the signal-to-noise ratio in a simple and efficient manner. For example, the pilot signal may be a mono frequent sinewave having a predetermined amplitude at a transmitter. Thus, the signal-to-noise ratio can be determined easily upon reception of the mono frequent sinewave and determination of the received amplitude.

In embodiments such a receiver is configured to receive a first signal portion and a second signal portion, wherein the second signal portion follows the first signal portion in time. Moreover, the receiver is configured to determine a signal-to-noise ratio based on the first signal portion and to adjust the length of the time period used for receiving a second signal portion based on the signal-to-noise ratio. Using a previously determined signal-to-noise ratio enables usage of a readily available previously determined signal-to-noise ratio. Thereby, it may not be necessary to determine a signal-to-noise ratio for said second signal portion as the previously determined signal-to-noise ratio can be used.

In embodiments such a receiver is configured to receive a first signal portion and a second signal portion, wherein the second signal portion follows the first signal portion in time. Furthermore, the receiver may be configured to obtain a first signal-to-noise ratio based on a pilot signal included in the first signal portion and to determine a second signal-to-noise ratio based on the second signal portion. Moreover, the receiver may be configured to determine a weighted signal-to-noise ratio based on the first and second signal-to-noise ratios. Determining a signal-to-noise ratio based on the first and second signal-to-noise ratios may improve accuracy of the determined weighted signal-to-noise ratio.

Embodiments provide a method for receiving a message with a receiver comprising a receive unit. The method comprises switching on the receive unit for a time period long enough to obtain a subportion or subportions of the coded message, wherein the coded message represents a message and is commonly coded using an FEC code with such a code rate that the coded messages decoded upon receipt of the subportion in time of the coded message or upon receipt of subportions of different transmissions of the coded message. Furthermore, the method comprises receiving a signal comprising the coded message, wherein there is a sequence of different transmissions associated with a message, a counter indicating the position of a respective transmission in a sequence and not commonly coded with the messages associated with a respective transmission. Moreover, the method comprises decoding a coded message. In embodiments, the method for receiving a message may be supplemented by all features and functionalities described herein with respect to the receiver embodiments.

Embodiments provide a method for transmitting a message. The method comprises commonly encoding a message into a coded message using an FEC code with such a code rated the coded messages decodable upon receipt of a subportion in time of the coded message or upon receipt of subportions of different transmissions of the coded message. Furthermore, the method comprises generating a sequence of different transmissions associated with the message, in which a counter indicating the position of a respective transmission in a sequence and not commonly coded with the messages associated with a respective transmission. Moreover, the method comprises transmitting the sequence of different transmissions. In embodiments, the method for transmitting a message may be supplemented by all features and functionalities described herein with respect to the transmitter embodiments.

Embodiments provide a method for transmitting a message and for receiving a message with a receiver comprising a receive unit. The method comprises commonly encoding a message into a coded message using an FEC coding with such a code rate that the coded message as decodable upon receipt of a subportion in time of the coded message or upon receipt of subportions of different transmissions of the coded message. Furthermore, the method comprises generating a sequence of different transmissions associated with a message, in which account indicating the position, not the respected transmission in a sequence and not commonly coded with the messages associated with a respective transmission. Moreover, the method comprises transmitting the sequence of different transmissions. Further, the method comprises switching on the receive unit for a time period long enough to obtain the subportion of subportions of the coded message from the sequence of different transmissions. Moreover, the method comprises receiving a signal comprising a subportion or subportions of the coded message and decoding the coded message based on the subportion or subportions of the coded message. Such a method may be supplemented by all features and functionalities described herein with respect to the methods for receiving a message and the methods for transmitting a message.

Embodiments provide a method for receiving a message with a receiver comprising a receive unit. The method comprises switching on the receive unit for a time period in order to receive a signal comprising a message and adjusting the length of a time period for which the receive unit is switched on, used for receiving a signal, based on a signal-to-noise ratio. Such a method may be supplemented by all features and functionalities described herein with respect to the corresponding receiver embodiments.

Embodiments provide a computer program with a program code for performing the methods described herein, when the computer program runs on a computer or a microcontroller.

### Brief Description of the Figures

In the following, embodiments of the present invention will be explained with reference to the accompanying drawings, in which:
- Fig. 1: depicts a block diagram of a receiver according to embodiments of the invention;
- Fig. 2A-B: shows transmission schematics according to embodiments of the invention;
- Fig. 3: depicts a block diagram of a receiver according to embodiments of the invention ;
- Fig. 4: depicts a block diagram of a transmission system according to embodiments of the invention;
- Fig. 5: depicts a block diagram of a transmitter according to embodiments of the invention;
- Fig. 6: depicts a block diagram of a receiver according to embodiments of the invention;
- Fig. 7A-B: shows transmission schematics according to embodiments of the invention;
- Fig. 8: shows transmission schematics according to embodiments of the invention;
- Fig. 9: shows a flow chart of a method for receiving a message according to embodiments of the invention;
- Fig. 10: shows a flow chart of a method for transmitting a message according to embodiments of the invention;
- Fig. 11: shows a flow chart of a method for transmitting and receiving a message according to embodiments of the invention;
- Fig. 12: shows a flow chart of a method for receiving a message according to embodiments of the invention;
- Fig. 13A-B: shows transmission schematics of conventional concepts.

### Detailed Description of Embodiments

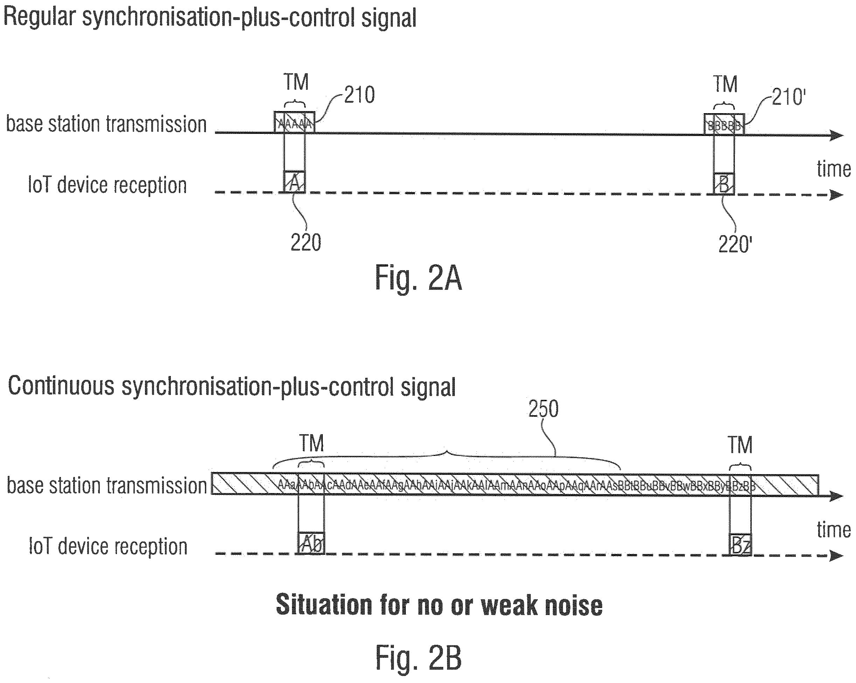

An idea underlying embodiments is to significantly reduce the code rate to encode a message in a base station and hence transmit this message in a longer burst, i.e. significantly longer than the message. A signal may be generated such that parts of the burst can be received and it may not be required to receive the full burst. This is illustrated in Fig. 2A, where a base station transmits long burst 210 and 210' associated with the message 'A' and B, respectively, and a receiver according to embodiments of the invention activates its receive unit for a time TM. In Fig. 2B a further option for the transmission is depicted, where a transmitter continuously transmits a transmission associated with message 'A' in a first time frame 250 and subsequently transmits a transmission associated with another message, as indicated with message 'B' in Fig. 2B. Similar to the described scheme in Fig. 2A, a receiver activates its receive unit for a time TM in Fig. 2B. The time TM in which the receive unit is active is shorter than the coded message, however due to appropriate encoding, e.g. with a low code rate and/or a suitable code, the receiver is still able to decode the messages 'A' and 'B' based on the subportions of the transmitted signal. Moreover, the time used for reception TM is significantly shorter than the time RT used in conventional approaches illustrated in Figs. 13A and 13B.

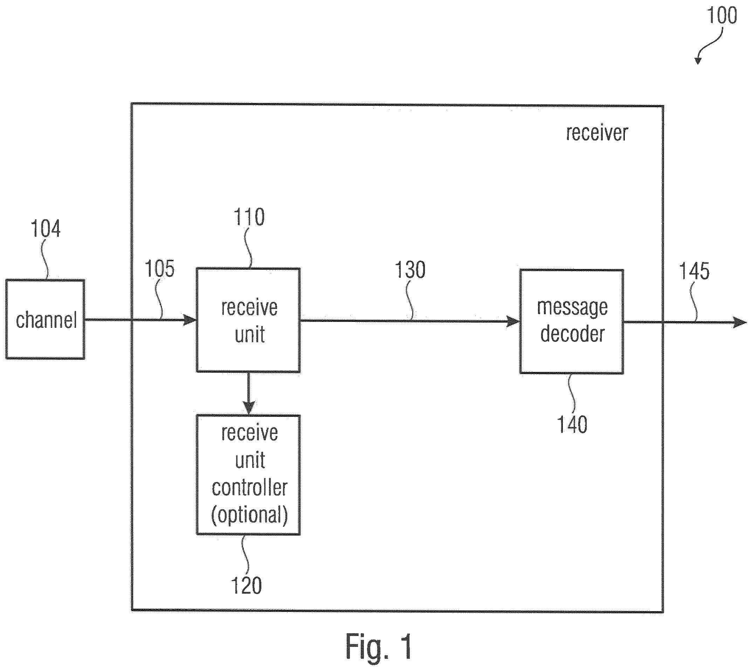

Fig. 1 depicts a block diagram of a receiver 100 according to embodiments of the invention. The receiver 100 comprises a receive unit 110. The receive unit 110 may be configured to receive a signal 105 via a channel 104. The receiver 100 may comprise a receive unit controller configured to switch on and off the receive unit 110. Furthermore, the receiver 100 comprises a message decoder 140. The message decoder is configured to receive a received signal 130 from the receive unit 130 and to decode a coded message based on the received signal 130 and to output a decoded message 145.

The receive unit controller 120 is configured to switch on the receive unit 110 for a time period long enough to obtain a portion of the transmitted signal 105 sufficient for the decoder to decode the encoded message. The length of the time period and, therefore, of the received signal 130 is chosen such that it comprises a subportion or subportions of different transmissions of the coded message such that the message decoder 140 is able to decode a message based on the received signal 130.

In embodiments, the receiver 100 may be configured to adjust the length of the switch on time period of the receive unit to enable a tradeoff between reception quality and power consumption of the receive unit 110. On one hand, by choosing a short time period for reception, a low power consumption of the receive unit, and therefore for the overall receiver 100, may be achieved. On the other hand, by using a long time period a reception quality can be increased and therefore the coded message comprised in the received signal may be decodable with less effort.

In embodiments, the the message decoder 140 is configured to decode the coded message 130 based on a subportion of the coded message. In embodiments, the message decoder 140 is configured to decode the coded message 130 based on subportions of different transmissions of the coded message. In a sequence of different transmissions associated with the message, each transmission may have associated therewith a respective counter indicating the position of the respective transmission in the sequence. The counter is not commonly FEC coded with the message. In embodiments, the message decoder 140 is configured to remove the counters from the different transmissions and to decode the message based on subportions of the remaining different transmissions.

In embodiments, the receive unit 100 may be implemented using analog circuitry and the message decoder 140 may be implemented using digital circuitry. Thus, the decrease in power consumption due to the reduced switch off time of the receive unit 100 may be larger than the increase of power consumption due to the possibly necessary additional computing effort in the message decoder.

Transmitters may use for transmitting the message, an encoding with a code rate significantly smaller than one. Furthermore, transmitters may use a Maximum-Distance-Separable code like a Reed-Solomon code for encoding the message, wherein for ideal reception conditions a subportion of length equal to the coded message suffices for decoding. Moreover, transmitters may use a BCH-code or Raptor-like (fountain/rateless code) codes for encoding the message, wherein for ideal reception conditions a subportion of length slightly longer than the message suffices for decoding the message. Transmitters may also employ repeatedly transmitting the message in order to encode the message, wherein such encoding results in a code rate of 1/N, where N is the number of repetitions.

Fig. 2A shows a transmission schematic using a transmitter included in a base station and a receiver, for example receiver 100, included in an loT device. In a first burst 210 the transmitter repeatedly transmits a message 'A' and the receiver obtains a signal portion of length TM wherefrom the receiver obtains the message 'A' 220. Furthermore, a second burst 210' is transmitted by the transmitter comprising a message 'B' being coded by repetition. The receiver captures a signal of length TM of the second burst 210' upon which the receiver is able to decode the message 'B' 220'. The length TM used for the receiver to obtain a subportion of the burst 210 or 210' is shorter than the burst 210 or 210' and shorter than RT used in conventional approaches.

Fig. 2B depicts a transmission schematic, wherein the transmitter is included in a base station and transmits a sequence of transmissions associated with a message. The transmissions are common encoding of the message with such a code rate that the message is decodable upon receipt of subportions of the coded message. Interspersed with the sequence, the sequence comprises counters which are not commonly coded with a message, indicated by lowercase letters. In a first sequence 250 the base station transmits the message 'A' and the loT device, e.g. comprising the receiver 100, captures a small portion of length TM of the sequence 250 to obtain the message 'A' and a counter 'b' therefrom. The captured small portion comprises a first transmission associated with the message 'AAb' and a second transmission associated with the message 'AAc'. Based on the first and second transmission associated with the message the loT device obtains 'Ab', i.e. message 'A' and the counter 'b'. As the counters, i.e. the lower case letters of the sequence, are not commonly coded with the message 'A' the coded message in the first and second transmission associated with the message 'A' can be cooperatively used to obtain message 'A'.

The receiver 100 may further be supplemented by all of the features and functionalities described herein.

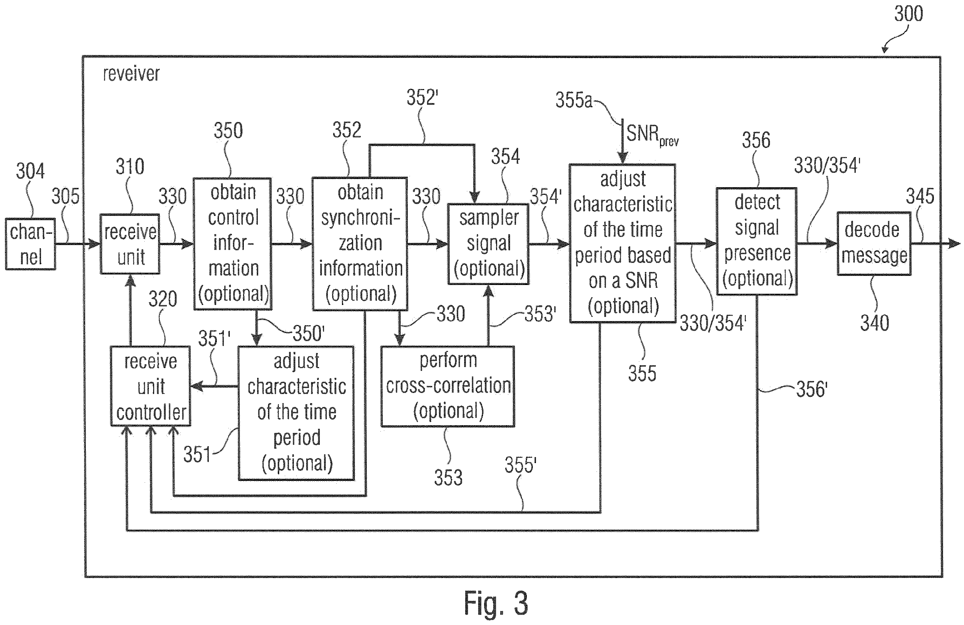

Fig. 3 depicts a block diagram of a receiver 300 according to embodiments of the invention, with similar functionality as the receiver 100. The receiver 300 comprises a receive unit 310 which based on a transmitted signal 305 provides a received signal 330. The receiver 300 comprises a receive unit controller 320 configured to switch on and off the receive unit 310. The receiver 300 further comprises a message decoder 340 which decodes a coded message based on the received signal 330 and provides the message 345. Moreover, the receiver 300 comprises an control information obtainer 350 configured to obtain control information 350' based on the received signal 330. The receiver 300 comprises a characteristic of the time period adjuster 351 which provides an adjusted characteristic 351' of the time period based on the control information 350'. Furthermore, the receiver 300 comprises a synchronization information obtainer 352 which provides synchronization information 352' based on the received signal 330. Moreover, the receiver 300 comprises a cross correlator 353 which provides a synchronization information 353' based on the received signal 330. The receiver 300 further comprises a signal sampler 354 configured to provide a sampled signal 354' based on the received signal 330. The receiver 300 comprises further a Signal-to-Noise Ratio (SNR) based adjuster 355 of the time period configured to provide a time period information 355' based on the received signal 330'. The receiver 300 comprises a signal presence detector 356 which based on the received signal 330 provides a signal presence information. The components (350, 351, 352, 353, 354, 355, 356) can be arranged in arbitrary order in the receiver, e.g. receiver 300, and the shown arrangement is only one option.

The receive unit 310 provides the received signal 330 based on the transmitted signal 305 obtained from a channel 304. The receive unit 310 is switched on by the receive unit controller 320 such that the received signal 330 comprises a subportion of the coded message or subportions of different transmissions of the coded message. The received signal 330 may be used in the control information obtainer 350 to obtain the control information 350' upon which the characteristic of the time period adjuster 351 provides the adjusted time period 351' to the receive unit controller 320. The receive unit controller 320 may use the adjusted characteristic of the time period 351' for switching on the receive unit 310 according to the adjusted characteristic of the time period 351'. Moreover, the synchronization information obtainer 352 obtains the synchronization information 352' from the received signal 330, the synchronization information 352' can be forwarded together with the received signal 330 to a signal sampler 354 to obtain the sampled signal 354'. Optionally, the synchronization information 353' can be obtained by performing a cross-correlation with a predetermined correlation sequence by the cross-correlation performer 353 and providing the synchronization information 353' to the signal sampler 354. The predetermined correlation sequence may be based on gold codes or maximum length codes. The time period adjuster 355 provides the time period information 355' to the receive unit controller based on a determined signal-to-noise ratio of a currently observed signal, for example received signal 330 or sampled signal 354' and/or a signal-to-noise ratio 355a (SNRₚᵣₑᵥ) of a previously received signal. Moreover, the receiver 300 may employ the signal presence detector 356 which, based on the received signal 330 or on the sampled signal 354', detects whether a signal comprising a message is present. If no signal comprising a message is detected by the signal presence detector, it is configured to pass the signal presence information 356', indicating no signal presence, to the receive unit controller 320 which in turn may switch off the receive unit. Thereby, reducing overall power consumption of the receiver 300 if the receive unit 310 can be switched off. Based on the received signal 330 or on the sampled signal 354' the message decoder 350 decodes the message 345 based on a subportion of the coded message or on subportions of the coded message obtained from the received signal 330 or the sampled signal 354'.

The receiver 300 flexibly enables decoding of a message based on subportions of a coded message, thereby enabling a low power consumption as the receive unit 310 and other optional elements used for reception and decoding of the message can be switched off when a sufficiently large portion of the coded message is obtained or no signal comprising a message is present.

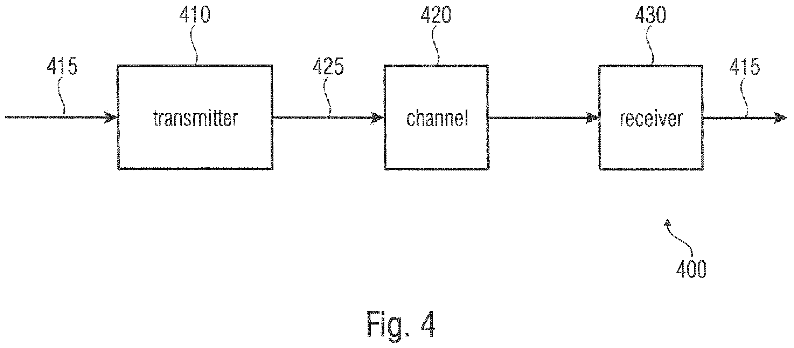

Fig. 4 depicts a block diagram of a transmission system 400 comprising a transmitter 410 and a receiver 430, e.g. receiver 100 or 200. The transmitter 410 transmits a signal 425 associated with a message 415, wherein the transmitter 410 is configured to generate the signal 425 such that it comprises a coded message coded with such a code rate that the message is decodable upon receipt of a subportion of the transmitted signal 425. The transmitted signal 425 passes through a channel 420 wherefrom the receiver 430 obtains a received signal. Based on the received signal which may only be a subportion of the transmitted signal, the receiver 430 decodes the coded message and provides the message 415 as output.

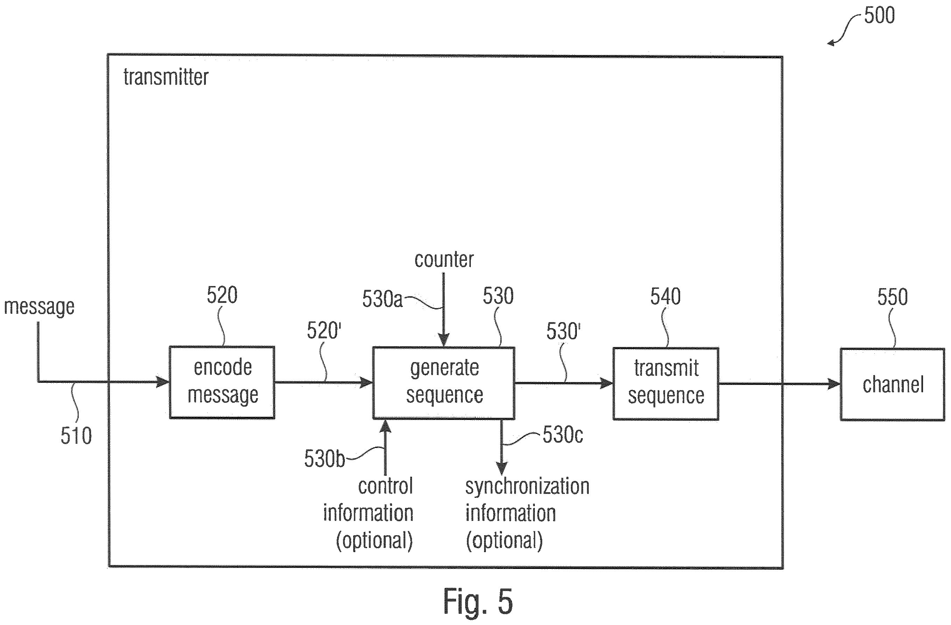

Fig. 5 depicts a block diagram of a transmitter 500 according to embodiments of the invention. The transmitter 500 comprises a message encoder 520, configured to encode a message 510, a sequence generator 530 configured to generate a sequence 530' based on a coded message 520', and a sequence transmitter 540 configured to transmit the sequence 530'.

The transmitter 500 takes the message 510 as input to produce an encoded message 520' in message encoder 520. Based on the encoded message 520' a sequence 530' is generated in the sequence generator 530. The sequence generator 530 introduces counter 530a and may further optionally introduce control information 530b and/or synchronization information 530c into the sequence 530' which are not commonly encoded with the message 510. The sequence 530' is used in the sequence transmitter 540 to transmit the sequence 530' into a channel 550, corresponding for example to channel 104 or 304.

The transmitter 500 encodes the message 510 in message encoder 520 to obtain the coded message 520', such that the message 510 can be decoded based on a subportion of the coded message 520'. Moreover, the transmitter 500 is configured to provide a sequence 530' of the coded message 520' which enables decoding of the message 510 based on a subportion of the encoded message 520, wherein the subportions may be associated with different transmissions of the coded message 520'. Thereby, a receiver can flexibly obtain the message 510 although not observing the entire sequence 530' or the entire encoded/coded message 520'. Upon reception of a subportion or subportions of the transmitted signal by a receiver, e.g. receiver 100 or 300, through the channel 550, the receiver can decode the message 510.

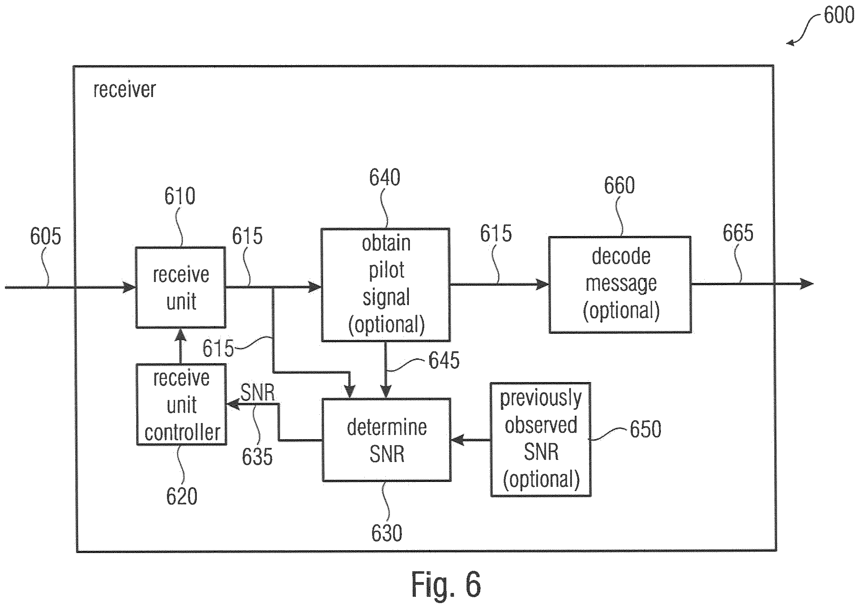

Fig. 6 depicts a block diagram of a receiver 600 according to embodiments of the invention. The receiver 600 comprises a receive unit 610, configured to obtain a received signal 615 based on a transmitted signal 605, a receive unit controller 620, configured to switch on and off the receive unit 610 based on a signal-to-noise ratio 635, an SNR determiner 630, configured to determine an SNR 635, an optional pilot signal obtainer 640, configured to obtain a pilot signal 645 based on the received signal 615 and an optional message decoder 660 which provides a message 665 based on the received signal 615.

The receive unit 610 is controlled by the receive unit controller 620 and activates or switches on the receive unit 610 based on a signal-to-noise ratio (SNR) 635. The SNR 635 may be known beforehand or determined by the SNR determiner 630 based on the received signals 615, wherein the received signal 615 is provided by the receive unit 610. Moreover, the receiver 600 may obtain a pilot signal 645 by the pilot signal obtainer 640 which obtains the pilot signal 645 based on the received signal 615. The pilot signal 645 may be based on a beforehand known waveform with a predetermined amplitude, wherein based on the observed attenuation of the waveform, i.e. pilot signal, the SNR 635 may be determined in the SNR determiner 630. Moreover, the SNR determiner 630 may determine the SNR based on the received signal 615 or based on a previously observed SNR 650. The SNR determiner 630 can flexibly choose any combination or weighting of the provided input, i.e. the received signal 615, the pilot signal 645 or the previously observed SNR 650, to determine an SNR estimate 635. The receive unit controller 620 can employ the estimated SNR 635 to adjust the time for which the receive unit will be switched on such that the received signal 615 with sufficient information is obtained to decode the message 665 in the optional message decoder 660 within reasonable time or with reasonable computational effort.

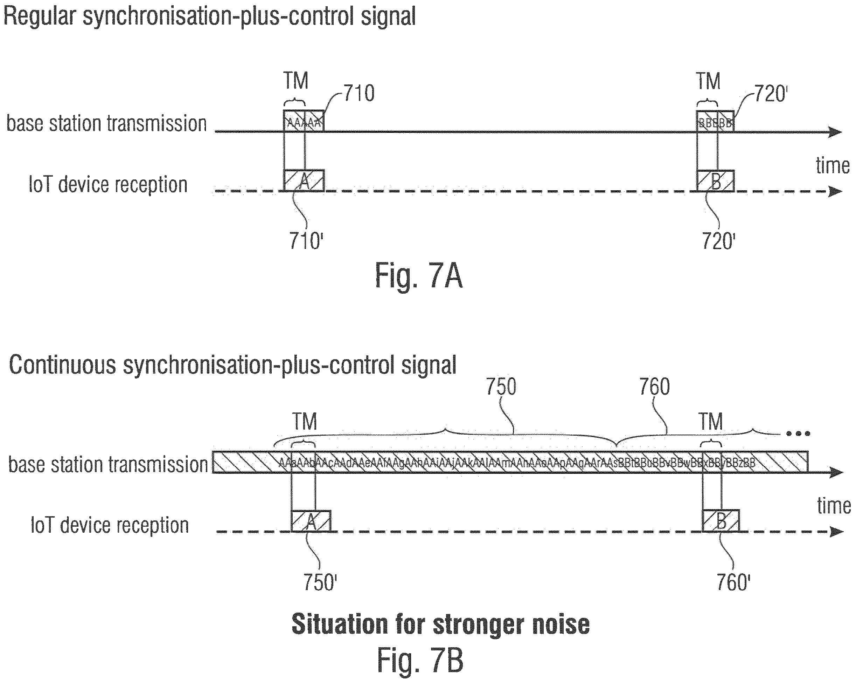

Fig. 7A shows a schematic of a transmission according to Fig. 2A, wherein the receiving loT device includes a receiver according to a receiver 600. In contrast to Fig. 2A non-ideal reception conditions are observed, i.e. the received signal is disturbed with noise. A base station transmits a first burst 710 longer than TM and the receiver captures the complete burst 710 in received portion 710' in order to obtain message 'A'. This is due to the fact that the received signal may comprise a low SNR and therefore reception quality is low and may be compensated by the extended reception period compared to the transmission scenario in Fig. 2A. Nevertheless, as the receiver in the loT device, for example the receiver 600, is able to receive a longer portion of the burst 710, e.g. the entire burst 710, the loT device is still able to decode the message 'A' within a reasonable time or with reasonable computational effort. Furthermore, in a second burst 720 the loT device receives a portion 720' corresponding to a complete burst 720 and based upon the reception decodes the message included in the burst 'B'.

Fig. 7B shows a transmission schematic according to Fig. 2B, wherein a receiver is used in the loT device corresponding to the receiver 600. In contrast to Fig. 2B non-ideal reception conditions are observed, i.e. the received signal is disturbed with noise. The receiver captures a portion 750' of the first sequence 750 longer than TM, to enable decoding the message 'A' as an increased background noise may be detected or in other words a low SNR is observed. In a second sequence 760 another message 'B' is transmitted by the base station and the receiver is able to decode the message 'B' upon reception of a received signal 760'.

The receiver, e.g. receiver 600, described with respect to Figs. 7A and 7B, is due to its flexibility in terms of reception time able to decode the message although it may be heavily distorted by background noise, e.g. thermal noise of the receiver.

The time used for reception of the portion 710', 720', 750' or 760' may be equal or even larger to RT in Figs. 13A and 13B. However, the scenario considered in the conventional approach in Figs. 13A and 13B assumed ideal conditions, i.e. high signal-to-noise ratio. A receiver according to receiver 300 can in contrast to a conventional receiver, employed in Fig. 13A and 13B, ensure safe reception even in adverse conditions, i.e. low signal-to-noise ratio.

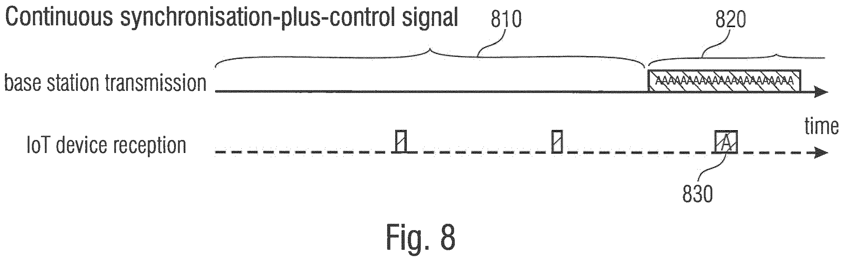

Fig. 8 shows a transmission scheme wherein the base station does not transmit for a first timeframe 810 and only starts transmission in a second timeframe 820. The loT device, may comprise one of the receivers 100, 200 or 600, switches on its receive unit during the first frame 810 to notice that no signal comprising a message is present. Upon not detecting a signal comprising a message during the first frame 810 the loT device, i.e. the receiver, turns off the receive unit immediately or shortly after switching on the receive unit. In the second timeframe 820 the loT device turns on the receive unit and detects a presence of a signal comprising a message, and therefore does not turn off the receive unit, but keeps it turned on such that a sufficiently large subportion of a coded message is obtained. Upon reception of the sufficiently large subportion 830 of the coded message the loT device decodes the message and obtains the message 'A'.

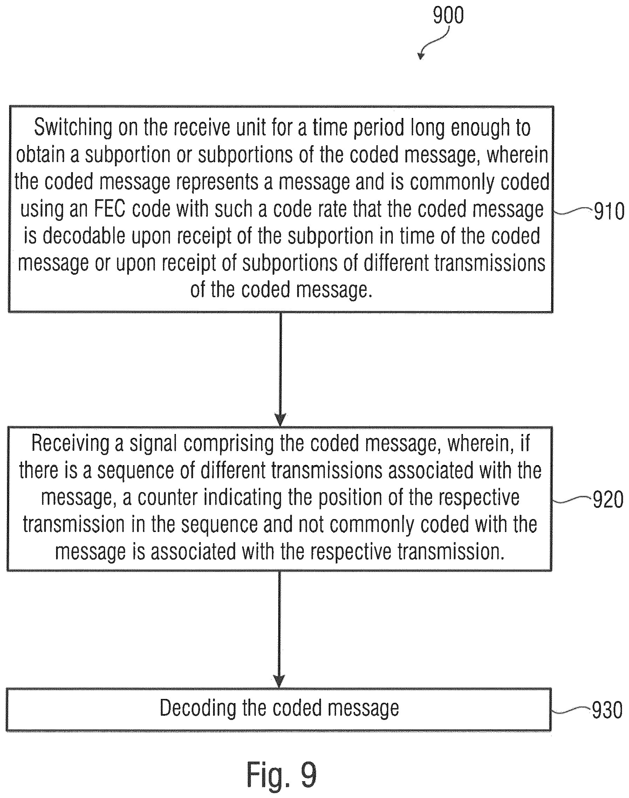

Fig. 9 shows a flowchart of a method 900 for receiving a message with the receiver comprising a receive unit. The method comprises switching on the receive unit for a time period long enough to contain a subportion or subportions of the coded message, wherein the coded message represents a message and is commonly coded using an FEC code with such a code rate the coded message is decodable upon receipt of the subportion in time of the coded message or upon receipt of subportions of different transmissions of the coded message 910. Furthermore, the method comprises receiving a signal comprising a coded message, wherein, if there is a sequence of different transmissions associated with the message, a counter indicating the position of the respective transmission in a sequence and not commonly coded with the messages associated with the respective transmission 920. Moreover, the method comprises decoding the coded message 930.

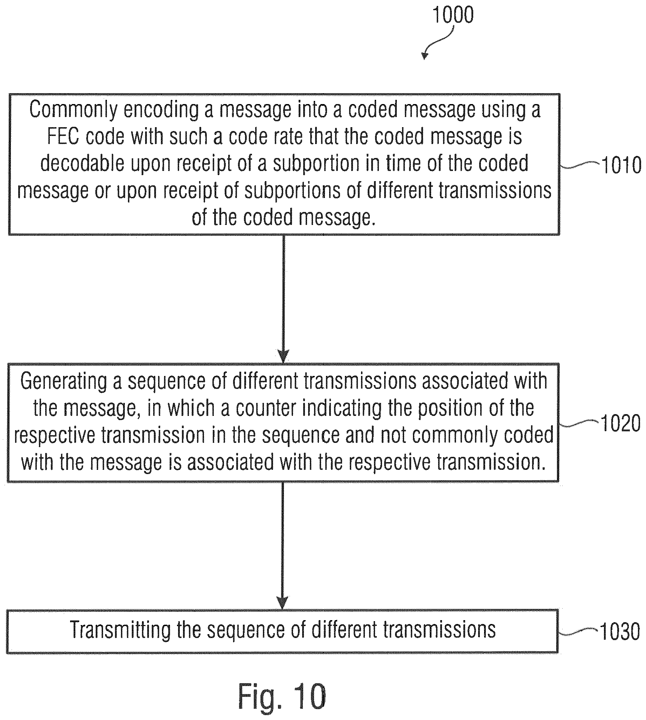

Fig. 10 shows a flowchart of a method 1000 for transmitting a message. The method comprises commonly encoding a message into a coded message using an FEC code with such a code rate that the coded messages decoder will upon receipt of a subportion in time of the coded message or upon receipt of subportions of different transmissions of the coded message 1010. Moreover, the method comprises generating a sequence of different transmissions associated with the message, in which a counter indicating the position of the respective transmission in the sequence and not commonly coded with the messages associated with the respective transmission 1020. Furthermore, the method comprises transmitting the sequence of different transmissions 1030.

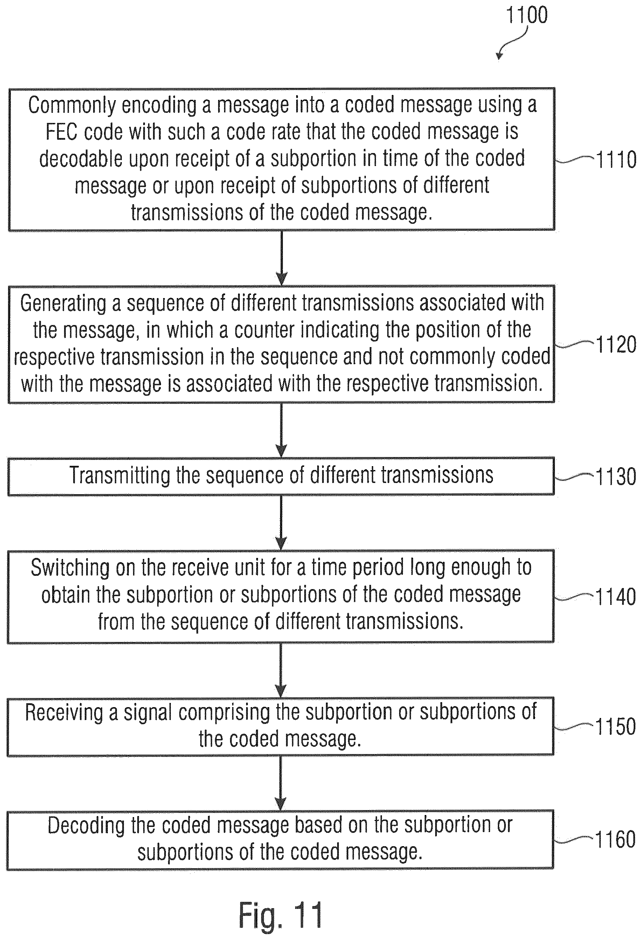

Fig. 11 shows a flowchart of a method 1100 for transmitting a message and receiving a message with a receiver comprising a receive unit. The message comprises commonly encoding a message into a coded message using an FEC code with such a decoded message is decodable upon receipt of a subportion in time of the coded message or upon receipt of subportions of different transmissions of the coded message 1110. Moreover, the method comprises generating a sequence of different transmissions associated with a message, in which a counter indicating the position of the respective transmission in a sequence not commonly coded with a message is associated with the respective transmission 1120. Furthermore, the method comprises transmitting the sequence of different transmissions 1130. The method further comprises, switching on the receiver for a time period long enough to obtain the subportion of subportions of the coded message from the sequence of different transmissions 1140. Furthermore, the method comprises receiving a signal comprising a subportion of subportions of the coded message 1150 in a further step, the method comprises decoding the coded message based on the subportion of subportions of the coded message 1160.

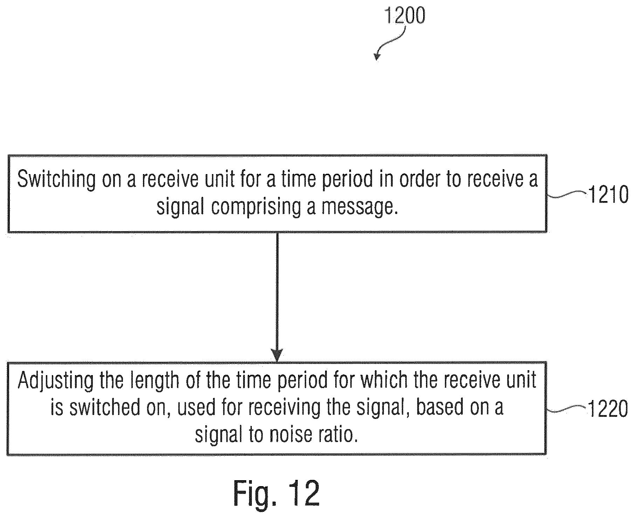

Fig. 12 shows a flowchart of a method 1200 for receiving a message with a receiver comprising a receive unit. The method comprises switching on a receive unit for a time period in order to receive a signal comprising a message 1210. Moreover, the method comprises adjusting the length of the time period for which the receive unit is switched on, used for receiving a signal, based on a signal-to-noise ratio 1220.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, one or more of the most important method steps may be executed by such an apparatus.

Depending on certain implementation requirements, embodiments of the invention can be implemented in hardware or in software. The implementation can be performed using a digital storage medium, for example a floppy disk, a DVD, a Blu-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein. The data carrier, the digital storage medium or the recorded medium are typically tangible and/or non-transitionary.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The apparatus described herein may be implemented using a hardware apparatus, or using a computer, or using a combination of a hardware apparatus and a computer.

The apparatus described herein, or any components of the apparatus described herein, may be implemented at least partially in hardware and/or in software.

The methods described herein may be performed using a hardware apparatus, or using a computer, or using a combination of a hardware apparatus and a computer.

The methods described herein, or any components of the apparatus described herein, may be performed at least partially by hardware and/or by software.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

### Further Aspects

In the sequel, a so-called "peeking" receiver is described, e.g. receiver 100, 300 or 600. The name was chosen because the receiver peeks from time to time at the channel, e.g. 104, 304 or 420, to check whether there is a message for it and in order to adjust its time synchronization. Hence, the solution is similar to the conventional approaches described above and displayed in the Fig. 13A. An aspect of the invention is that the peeks (i.e. power-up times of the receiver branches (i.e. receive unit)) can be made shorter in the proposed solution.

An aspect underlying embodiments of the invention is to significantly reduce the code rate to encode the message in the base station and hence transmit this message in a longer burst. The signal is generated such that parts of the burst can be received and it is not required to receive the full burst. An loT device, e.g. comprising receiver 100, 300 or 600, can switch on its receiver branch at some point inside this burst and receive for sufficiently long time to ensure that the message can be decoded. For instance, let us consider a system designed for high signal-to-noise ratios (SNR) and assume a conventional system with uncoded signalling data, i.e. code rate R_{conv} = 1, such that the message duration is TM. In general, this code rate is chosen such that the detrimental effects of noise and interference are sufficiently mitigated in all targeted receivers. In the conventional approach, due to time synchronisation offsets, the loT device has to switch on at time T1' before the expected burst start T1 and has to remain on until a time T2' equal to or after the end T2 of the burst, such that T2'-T1' > T2-T1 = TM. Instead, for the proposed solution, let us assume a code rate R_{Peek} << R_{conv} =1. The receiver switches on at some time T1' after T1 and remains on until T2' = T1'+TM, where T2' <= T2. Hence, in the conventional approach, the active reception time is T2'-T1' > TM, while it can be T2'-T1' = TM in the proposed solution. In both cases, the same number of code symbols of the encoded message are received in the loT device. Using a suitable forward error correction (FEC) code, the decoding performance is in both cases identical (in case of a Maximum-Distance-Separable code like a Reed-Solomon code) or very similar (e.g. using BCH-codes or Raptor-like codes). For these codes, it suffices to receive any arbitrary k' code symbols in order to successfully decode k message symbols, where k' is equal to k (MDS codes) or slightly larger (e.g. Raptor-codes). A simple system could use a repetition code where the code symbols associated with a message (e.g. D0,D1,D2,D3,D4) are just repeated multiple times (D0,D1,D2,D3,D4, D0,D1,D2,D3,D4, D0,D1,D2,D3,D4, D0,D1,D2,D3,D4). Then the receiver can start reception at any point in time and just receive five consecutive code symbols (e.g. D2,D3,D4,D0,D1). Regular transmission of synchronization sequences (e.g. IDs or control information) may also be necessary for this scheme so that the receiver can put them in order.

Similarly, the base station, e.g. comprising transmitter 500, could choose to transmit continuously instead of transmitting bursts. By contrast to the conventional approach in Fig. 13B, the base station does not append the counter to the repeated message payload A anymore before the FEC encoding, but repeatedly transmits a first part, which carries the encoded message payload A (and later B), and a second part, which carries the incremented counter (indicated by a lower case letter in the figure, e.g. the "b" in "Ab"). A message payload of length k symbols is encoded either into a codeword that constitutes the first part and that is repeated many times (once per incremented counter value) until the message payload A is replaced by B. Or the message payload of length k symbols is encoded by a very low-rate code into a very long code word. Each first part, each representing a different transmission associated with the message, then only contains a section of length ≥ k of this long codeword. In general but not necessarily, different first parts will contain different sections of the codeword. Potentially, after a given number of first parts, the same sections are repeated in the following first parts. When the message payload A is replaced by B, then a new very long codeword is produced and sections thereof are transmitted in the first parts.

The loT devices then only have to switch on at an arbitrary time during this transmission over a duration TM in order to receive sufficiently many code symbols k' >= k from the first parts to ensure decoding success. When message payload A is outdated, the base station immediately switches to the transmission of the next message payload B.

Alternatively, the transmission could be interrupted and individual symbols or sequences of symbols could not be transmitted. This could be necessary to allow the base station to receive sensor nodes (e.g. loT devices), when simultaneous transmission and reception is not possible. The symbols before and after such an interruption can be associated with the same message. The same message may thus be transmitted over a time interval with multiple interruptions. In other words, devices comprising one of the receiver 100, 300 or 600 may be able to also transmit messages to a base station which for example comprises the transmitter 500.

The description above is valid for the case that the influence of (thermal) noise (and interference) is negligible. However, the noise power might be significant in some loT devices, while others suffer from very little noise. For high signal-to-noise ratios (SNR), the duration of the reception can be kept close to TM, i.e. a little more than k symbols need to be received out of the signal from the base station. For low SNRs, a larger redundancy is required in the FEC decoder in order to correct more transmission errors caused by the noise. Hence, the loT device switches on for a longer time than TM (this could be up to the duration of the burst) and receives far more than k code symbols. Each loT device can decide individually, how many code symbols it requires for its specific SNR, and how long it has to switch on accordingly. Hence, devices experiencing higher SNR and powering up their receiver branch (e.g. receive unit 110, 310 or 610) over shorter time consume less power on average, while devices at low SNR consume more power.

Besides the messages, e.g. control information, the signal from the base station moreover may convey synchronisation signals (preambles) (e.g. synchronization information) in order to allow the loT devices to adjust their time and frequency synchronisation. The synchronisation sequences are scattered over the complete transmitted burst such that even for the minimum power-on time TM (i.e. the time to receive k' symbols equal to the length k of the uncoded message), there is at least one synchronisation sequence inside the received signal. The length of this synchronisation sequence is as short as possible while ensuring that for no or weak noise, the loT device can re-synchronize sufficiently using such a sequence/preamble. For stronger noise, accordingly multiple such synchronization sequences are needed for the re-synchronisation, just like more code symbols have to be received for decoding success in the presence of strong noise. Accordingly, the (small) synchronization sequences are distributed over the burst. This means that the minimum reception duration is just long enough to receive sufficiently many code symbols for decoding the message and sufficiently many preamble symbols (e.g. synchronization information) to remain time- and frequency-synchronized. Each loT device can thus select its reception duration individually depending on the SNR that it experiences.

Observe that the described solution is different from a wakeup receiver: while the wakeup receiver has its ultra-low-power receiver circuit running all the time, the peeking receiver switches its (more powerful and thus more power-hungry) receiver circuit on only over short periods of the time.

A wakeup functionality, i.e. activating the loT device at an arbitrary instant, could be realized with the described peeking receiver in the following way: the receiver peeks at the radio channel at regular instants separated not far in time. When it detects by a certain probability that there is no base station transmission ongoing (e.g. low power of the receive signal), it can stop its active reception quickly. Only, when the loT device detects a base station transmission with sufficiently high probability, it receives over the full duration of the message, as illustrated in Fig. 8.

An aspect of the invention is a receiver which switches on some time inside the transmitted burst/signal and receives over a time shorter than the burst duration (or total duration over which a message is transmitted). Furthermore, the receiver may adapt the time to the specific SNR experienced by the receiver.

Furthermore, embodiments describe signaling for and realization of peeking receivers and signalling/transmission for and realization of improved Peeking Receivers. Moreover, the described embodiments of receivers may be incorporated in various devices benefiting from low power consumption, e.g. loT devices or any battery driven devices.

A further aspect of the invention is a waveform/signalling where the synchronisation sequences are scattered over the complete transmitted burst in the following manner:
- the synchronisation symbols inside the transmitted signal are organized in a pattern, such that even for the minimum power-on time TM and an arbitrary consecutive interval of length TM within the transmit signal, there are sufficient synchronisation symbols to achieve synchronisation at the SNRₘₐₓ that corresponds to TM. Examples:
   - one synchronisation sequence of sufficient length in regular distances TM
   - regular scattering of individual synchronisation symbols such that sufficiently many are within an interval TM
- when the receiver experiences a signal-to-noise ratio SNR₀ < SNRₘₐₓ and the loT device accordingly has to receive over a time X > TM in order to receive sufficiently many code symbols for successful decoding, then the synchronisation symbols are distributed in such a way within the transmit signal, that the received segment of length X of the transmit signal conveys sufficiently many synchronisation symbols to allow (re-) synchronisation for this specific SNR₀.

Another aspect of the invention is a waveform/signalling where the Forward Error Correction (FEC) code symbols are scattered over the complete transmitted burst in the following manner:
- each frame of the signal is split into two parts (containing - among others - encoded message payload and an incremented counter, resp.). This allows the combination of symbols from the first parts (i.e. encoded message payload) from multiple frames and joint decoding thereof in order to retrieve the message payload in case of a random power-on time (i.e. not aligned to the frames) or in case of reception over multiple frames (due to low SNR)
- Use of a FEC code that is able recover the transmitted information at SNRₘₐₓ, when the code symbols within an arbitrarily located window of length TM are received
- When the SNR is SNR₀<SNRₘₐₓ then the FEC code is able to recover the transmitted information (e.g. message) from the code symbols within an arbitrarily located window of length X > TM, where X is the same X as defined for the synchronisation symbols above for the given SNR₀.

A further aspect of the invention is a receiver that stops the reception as soon as possible when no transmission signal is detected.

Further aspects are:
1. Higher sensitivity than the wakeup receiver solution
2. Higher bandwidth-efficiency of the base station signal than the conventional wakeup receiver solution
3. Shorter power-on times and hence lower power consumption than the conventional peeking receiver solution
4. Individual adaptation of the power-up times and hence power consumption to the specific SNR of each loT device

**Comparision of proposed peeking receiver, conventional wake up receiver and LTE receiver.**

| Category | Conventional LTE Receiver | Conventional Wake Up Receiver | Proposed Peeking Receivers |
|---|---|---|---|
| Sensitivity | Low | Medium | High |
| Bandwidth efficiency of base station signal | High | Medium | High |
| Power-on time | High | Medium | Low |
| Power-up time | Non-adaptive | Non-adaptive | Adaptive to SNR |

## Claims

1. A receiver (100; 300) comprising a receive unit (110; 310),
wherein the receiver is configured to receive a signal (130; 330) comprising
a coded message representing a message (145; 345), commonly coded using a FEC code with such a code rate that the coded message is decodable upon receipt of a subportion in time of the coded message or upon receipt of subportions of different transmissions of the coded message,
wherein, if there is a sequence of different transmissions associated with the message, a counter indicating the position of the respective transmission in the sequence and not commonly coded with the message (145; 345) is associated with the respective transmission, and
wherein the receiver is configured to switch on the receive unit (110; 310) for a time period long enough to obtain the subportion or subportions of the coded message and to decode the coded message.

2. Receiver according to claim 1, wherein the receiver is configured to switch on the receive unit for a time period not longer than the length of the coded message.

3. Receiver (100; 300)in accordance to claim 1 or claim 2, wherein the receiver is configured to obtain a control information (350') from the received signal, and
wherein the receiver is configured to adjust a characteristic of the time period based on the control information (350') obtained from the received signal (130; 330).

4. Receiver (100; 300) in accordance to claim 3, wherein the receiver is configured to adjust a periodicity of the time period based on the control information (350') obtained from the received signal (130; 330) in order to synchronize switch on times of the receive unit (110; 310) with transmission times of the message (145; 345).

5. Receiver (100; 300) in accordance to one of the claims 1 to 4, wherein the receiver (100; 300) is configured to obtain a synchronization information (352', 353') from the received signal (130; 330), and wherein the receiver (100; 300) is configured to adjust a clock of the receiver (100; 300), used for sampling of the received signal(130; 330), based on the synchronization information (352', 353').

6. Receiver (100; 300) according to claim 5, wherein the receiver (100; 300) is configured to adjust a length of the received signal (130; 330) such that the synchronization information (352', 353') is obtained from the received signal (130; 330).

7. Receiver (100; 300) in accordance to claim 5 or claim 6, wherein the receiver (100; 300) is configured to obtain the synchronization information (353') on the basis of a cross correlation performed on the received signal (130; 330).

8. Receiver (100; 300) in accordance to one of the claims 1 to 7, wherein the receiver (100; 300) is configured to adjust a length of the time period for which the receive unit (110; 310) is switched on to be dependent on a signal-to-noise ratio.

9. Receiver (100; 300) in accordance to claim 8, wherein the receiver (100; 300) is configured to increase the length of the time period for which the receive unit (110; 310) is switched on if a current signal-to-noise ratio is lower than a previously observed signal-to-noise ratio.

10. Receiver (100; 300) in accordance to one of the claims 1 to 9, wherein the receiver (100; 300) is configured to switch on the receive unit (110; 310) and to switch off the receive unit (110; 310) in response to not observing a receive signal.

11. Receiver (100; 300) in accordance to one of the claims 1 to 10, wherein the receiver (100; 300) is configured to obtain the coded message being coded with an erasure code, and wherein the receiver (100; 300) is configured to decode the message (145; 345) based on the subportion of the coded message.

12. Receiver (100; 300) in accordance to one of the claims 1 to 11, wherein the receiver (100; 300) is configured to obtain the coded message, wherein the message (145; 345) is coded by repetition of the message (145; 345), wherein the receiver (100; 300) is configured to decode the message (145; 345) upon reception of one repetition of the message (145; 345) or upon reception of subportions of at least two repetitions of the message (145; 345).

13. Receiver (100; 300) in accordance to one of the claims 1 to 12, wherein the receiver is configured to delay a switch-on time of its receive unit in dependence on a known, assumed or measured frequency stability of the receiver's local oscillator.

14. A transmitter (500) configured to:
commonly encode a message (510) into a coded message using a FEC code with such a code rate that the coded message (520') is decodable upon receipt of a subportion in time of the coded message (520') or upon receipt of subportions of different transmissions of the coded message (520'),
generate a sequence (530') of different transmissions associated with the message (510), in which a counter (530a) indicating the position of the respective transmission in the sequence (530') and not commonly coded with the message (510) is associated with the respective transmission, and
transmit the sequence of different transmissions.

15. Transmitter (500) according to claim 14, wherein the transmitter (500) is configured to include a control information (530b) into the transmitted sequence (530') of different transmissions, wherein the control information (530b) is configured to adjust a time period used for reception of the transmitted signal of a receiver.

16. Transmitter (500) according to claim 15, wherein the transmitter (500) is configured to include the control information (530b) into the transmitted sequence (530') of different transmissions, wherein the control information (530b) is configured to synchronize switch on times of a receiver with transmission times of the message (510).

17. Transmitter (500) in accordance to one of the claims 14 to 16, wherein the transmitter (500) is configured to include a synchronization information (530c) into the transmitted sequence (530') of different transmission, and wherein the synchronization information (530c) is configured to adjust a clock of a receiver, used for sampling of the transmitted signal upon reception by the receiver.

18. Transmitter (500) according to claim 17, wherein the transmitter (500) is configured to include synchronization information (530c) periodically into the transmitted sequence (530') such that the receiver is able to obtain a synchronization information upon reception of a subportion of the transmitted sequence.

19. Transmitter (500) in accordance to claim 17 or claim 18, wherein the synchronization information (530c) is included in the transmitted signal such that it enables a cross correlation based retrieval of the synchronization information (530c) by the receiver.

20. Transmitter (500) in accordance to one of the claims 14 to 19, wherein the transmitter (500) is configured obtain the coded message (520') by coding the message (510) with an erasure code, such that a receiver is able to decode the message (510) upon reception of a subportion of the coded message (520').

21. Transmitter (500) in accordance to one of the claims 14 to 20, wherein the transmitter (500) is configured to obtain the coded message (520') by coding the message (510) by repetition of the message (510) such that a receiver is able to decode the message (510) upon reception of one repetition of the message (510) or upon reception of subportions of at least two repetitions of the message (510).

22. Transmitter (500) in accordance to one of the claims 14 to 21, wherein the transmitter is configured to advance a transmission of a message in dependence on a known, assumed or measured frequency stability of a receiver's local oscillator.

23. Transmission system (400) comprising
a receiver (100; 300; 430) according to one of the claims 1 to 13, and
a transmitter (410; 500).

24. Transmission system (400) according to claim 23, wherein the transmitter (410; 500) is a transmitter (410; 500) according to one of the claims 14 to 21, and
wherein the transmitter (410; 500) is configured to transmit the sequence (530') of different transmissions associated with the message (510).

25. Transmission system (400) according to claim 23, wherein the transmitter (410; 500) is configured to periodically transmit coded messages (520'), with such a code rate that the coded messages (520') are decodable upon reception of subportions of the coded messages.

26. A Receiver (600) comprising a receive unit (610), wherein the receiver (600) is configured to switch on the receive unit (610) for a time period in order to receive a signal (615) comprising a message (665),
wherein the receiver (600) is configured to adjust the length of the time period for which the receive unit (610) is switched on for receiving the signal (615), based on a signal-to-noise ratio (635).

27. Receiver (600) according to claim 26, wherein the received signal (615) comprises
a subportion in time of a message (665), wherein the message (665) is coded with such a code rate that it is decodable based on the received subportion, and
wherein the receiver (600) is configured to decode the message (665).

28. Receiver (600) according to claim 26 or claim 27, wherein the receiver (600) is configured to receive a pilot signal (645) included in a currently received signal portion (615), and wherein the receiver (600) is configured to determine a signal-to-noise ratio (635) based on the received pilot signal (645).

29. Receiver (600) in accordance to one of the claims 26 to 28, wherein the receiver (600) is configured to receive a first signal portion and a second signal portion,
wherein the second signal portion follows the first signal portion in time,
wherein the receiver is configured to determine a signal-to-noise ratio (650) based on the first signal portion, and
wherein the receiver is configured to adjust the length of the time period used for receiving the second signal portion based on the signal-to-noise ratio (635).

30. Receiver (600) in accordance to one of the claims 26 to 29,
wherein the receiver (600) is configured to receive a first signal portion and a second signal portion,
wherein the second signal portion follows the first signal portion in time,
wherein the receiver is configured to obtain a first signal-to-noise ratio based on a pilot signal (645) included in the first signal portion, and
wherein the receiver is configured to determine a second signal-to-noise ratio based on the second signal portion,
wherein the receiver is configured to determine a weighted signal-to-noise ratio (635) based on the first and second signal-to-noise ratio.

31. Method for receiving a message with a receiver comprising a receive unit comprising:
switching on the receive unit for a time period long enough to obtain a subportion or subportions of the coded message,
wherein the coded message represents a message and is commonly coded using a FEC code with such a code rate that the coded message is decodable upon receipt of the subportion in time of the coded message or upon receipt of subportions of different transmissions of the coded message,
receiving a signal comprising the coded message,
wherein, if there is a sequence of different transmissions associated with the message, a counter indicating the position of the respective transmission in the sequence and not commonly coded with the message is associated with the respective transmission, and
decoding the coded message.

32. Method for transmitting a message comprising:
commonly encoding a message into a coded message using a FEC code with such a code rate that the coded message is decodable upon receipt of a subportion in time of the coded message or upon receipt of subportions of different transmissions of the coded message,
generating a sequence of different transmissions associated with the message, in which a counter indicating the position of the respective transmission in the sequence and not commonly coded with the message is associated with the respective transmission, and
transmitting the sequence of different transmissions.

33. Method for transmitting a message and for receiving a message with a receiver comprising a receive unit comprising:
commonly encoding a message into a coded message using a FEC code with such a code rate that the coded message is decodable upon receipt of a subportion in time of the coded message or upon receipt of subportions of different transmissions of the coded message,
generating a sequence of different transmissions associated with the message, in which a counter indicating the position of the respective transmission in the sequence and not commonly coded with the message is associated with the respective transmission, and
transmitting the sequence of different transmissions,
switching on the receive unit for a time period long enough to obtain the subportion or subportions of the coded message from the sequence of different transmissions,
receiving a signal comprising the subportion or subportions of the coded message, and
decoding the coded message based on the subportion or subportions of the coded message.

34. Method for receiving a message with a receiver comprising a receive unit comprising
switching on the receive unit for a time period in order to receive a signal comprising a message, and
adjusting the length of the time period for which the receive unit is switched on, used for receiving the signal, based on a signal to noise ratio.

35. Computer program with a program code for performing a method according to one of the claims 31 to 34, when the computer program runs on a computer or a microcontroller.
